# EUROPEAN PATENT APPLICATION

(11) **EP 4 465 339 A1**
(43) Date of publication of application: **20.11.2024**
(21) Application number: 22920510.9
(22) Date of filing: 07.12.2022
(51) Int. Cl.: H01L 21/02, G05B 19/418, G05B 23/02, H01L 21/304

(54) **APPROPRIATENESS DETERMINATION DEVICE AND APPROPRIATENESS DETERMINATION METHOD**

(30) Priority: 13.01.2022 JP 2022003998
(71) Applicant: SCREEN Holdings Co., Ltd., Kyoto-shi, Kyoto 602-8585 (JP)
(72) Inventor: MATSUI, Hiroakira, Kyoto-shi, Kyoto 602-8585 (JP); SEIWA, Takaaki, Kyoto-shi, Kyoto 602-8585 (JP); INAGI, Dai, Kyoto-shi, Kyoto 602-8585 (JP); UENO, Tomohiro, Kyoto-shi, Kyoto 602-8585 (JP); NAKANO, Yuta, Kyoto-shi, Kyoto 602-8585 (JP); YOSHIHARA, Koki, Kyoto-shi, Kyoto 602-8585 (JP); ONO, Takuya, Kyoto-shi, Kyoto 602-8585 (JP)
(74) Representative: Kilian Kilian & Partner mbB
(86) International application number: PCT/JP2022/045131
(87) International publication number: WO 2023/135990

(57) **Abstract**

A propriety determination device includes a dummy information generator that generates dummy information by replacing at least part of the plurality of processing information pieces collected from the substrate processing apparatus with a dummy data piece and provides the dummy information to the information analysis device, and a determiner that determines whether a detecting operation of the information analysis device is proper by determining whether the invariant relationships set in the information analysis device are adapted to the substrate processing apparatus based on whether, in a case in which the dummy information is provided to the information analysis device by the dummy information generator, an abnormality in the substrate processing apparatus has been detected by the information analysis device.

## Description

### [Technical Field]

The present invention relates to a propriety determination device and a propriety determination method for determination whether detection of an abnormality in a substrate processing apparatus by an information analysis device is proper.

### [Background Art]

A substrate processing apparatus is used to execute various processes on various substrates such as a semiconductor substrate. In the substrate processing apparatus, a series of processes is executed on a substrate in accordance with a predetermined processing procedure (processing recipe), for example. In order to prevent an occurrence of a processing defect in a substrate due to an abnormality in a substrate processing apparatus, a data processing system for making determination in regard to an abnormality in a substrate processing apparatus has been proposed (see Patent Document 1, for example).

In the data processing system, a plurality of physical quantities relating to a substrate processing apparatus are measured during a process for a substrate, and these measurement results are arranged in a chronological order, so that a plurality of time-series data pieces are generated. The plurality of time-series data pieces include data of the physical quantities such as a flow rate of a processing liquid discharged from a nozzle and a pressure in a chamber, for example. Each time-series data piece is compared with predetermined reference data, so that an evaluation value is calculated. It is determined whether an abnormality is present in the time-series data piece based on the calculated evaluation value.
[Patent Document 1] JP 2020-047847 A

### [Summary of Invention]

### [Technical Problem]

In the determination of an abnormality in the substrate processing apparatus, in a case in which a processing recipe of the substrate processing apparatus is changed, various appliances included in the substrate processing apparatus are updated, etc., it is necessary to adjust the reference data of the data processing system. In a case in which the reference data of the data processing system is improper, an abnormality in the substrate processing apparatus is not properly determined. In a case in which whether determination of an abnormality in the substrate processing apparatus is proper is confirmed, it is necessary to check the state of the substrate processing apparatus and check the setting of the data processing system. These checking work is complicated.

An object of the present invention is to provide a propriety determination device and a propriety determination method with which it is possible to easily determine whether detection of an abnormality in a substrate processing apparatus by an information analysis device is proper.

### [Solution to Problem]

(1) A propriety determination device according to one aspect of the present invention that determines whether a detecting operation of an information analysis device is proper, wherein the information analysis device is configured to detect an abnormality in a substrate processing apparatus based on invariant relationships in regard to a plurality of processing information pieces representing operations or states relating to a process for a substrate by the substrate processing apparatus and a plurality of actually collected processing information pieces, and the propriety determination device includes a dummy information generator that generates dummy information by replacing at least part of the plurality of processing information pieces collected from the substrate processing apparatus with a dummy data piece and provides the dummy information to the information analysis device, and a determiner that determines whether a detecting operation of the information analysis device is proper by determining whether the invariant relationships set in the information analysis device are adapted to the substrate processing apparatus based on whether, in a case in which the dummy information is provided to the information analysis device by the dummy information generator, an abnormality in the substrate processing apparatus has been detected by the information analysis device, and the dummy data piece is set such that an abnormality in the substrate processing apparatus is detected by the information analysis device when, in a case in which the invariant relationships set in the information analysis device are adapted to the substrate processing apparatus, the dummy information is provided to the information analysis device.
   With this propriety determination device, dummy information including a dummy data piece of the substrate processing apparatus is generated by the dummy information generator. The dummy information is provided to the information analysis device by the dummy information generator. Here, the dummy data piece is set such that, in a case in which invariant relationships set in the information analysis device are adapted to the substrate processing apparatus, when dummy information is provided to the information analysis device, an abnormality in the substrate processing apparatus is detected by the information analysis device. That is, in a case in which the invariant relationships set in the information analysis device are adapted to the substrate processing apparatus, when dummy information is provided to the information analysis device, an abnormality in the substrate processing apparatus is detected by the information analysis device. On the other hand, in a case in which the invariant relationships set in the information analysis device are not adapted to the substrate processing apparatus, when dummy information is provided to the information analysis device, an abnormality in the substrate processing apparatus may not be detected by the information analysis device. Therefore, it is possible to determine whether the invariant relationships set in the information analysis device are adapted to the substrate processing apparatus based on whether an abnormality in the substrate processing apparatus is detected by the information analysis device when dummy information is provided to the information analysis device. Thus, it is possible to easily determine whether a detecting operation of the information analysis device is proper.
(2) The determiner may determine that a detecting operation of the information analysis device is improper in a case in which, when the dummy information is provided to the information analysis device by the dummy information generator, an abnormality in the substrate processing apparatus is not detected by the information analysis device.
   In this case, it is possible to easily determine that a detecting operation of the information analysis device is improper.
(3) The propriety determination device may further include a notifier that makes notification that a detecting operation of the information analysis device is improper in a case in which, when the dummy information is provided to the information analysis device, it is determined that the detecting operation of the information analysis device is improper.
   In this case, it is possible to recognize easily and quickly that a detecting operation of the information analysis device is improper.
(4) The propriety determination device may further include a dummy information transmission instructor that provides, to the dummy information generator, an instruction for transmitting the dummy information to the information analysis device, and the dummy information generator, in a case in which the dummy information transmission instructor has not provided the instruction for transmitting the dummy information, transmits the plurality of processing information pieces collected from the substrate processing apparatus to the information analysis device, and in a case in which the dummy information transmission instructor has provided the instruction for transmitting the dummy information, transmits the dummy information generated by the dummy information generator to the information analysis device.
   In this case, with an instruction provided by the dummy information transmission instructor, it is possible to appropriately switch between an abnormality detecting operation of detecting an abnormality in the substrate processing apparatus performed by the information analysis device, and determination, made by the propriety determination device, whether a detecting operation of the information analysis device is proper.
(5) The propriety determination device may further include an output switcher that receives a result in regard to a detecting operation of the information analysis device and transmits the received result in regard to the detecting operation to the substrate processing apparatus or the determiner, wherein in a case in which the dummy information is provided to the information analysis device, the output switcher does not have to transmit the received result in regard to the detecting operation to the substrate processing apparatus.
   In this case, when it is determined whether a detecting operation of the information analysis device is proper, provision of a detection result of an abnormality in the substrate processing apparatus caused by dummy information is prevented. Thus, a user is prevented from erroneously identifying whether the substrate processing apparatus is abnormal.
(6) The dummy information generator may replace a processing information piece relating to a continuously operating constituent element among a plurality of constituent elements included in the substrate processing apparatus with the dummy data piece, and the dummy data piece may be set to a value deviating from the processing information piece relating to the constituent element.
   In this case, in a case in which the invariant relationships set in the information analysis device are adapted to the substrate processing apparatus, when dummy information is provided to the information analysis device, an abnormality in the substrate processing apparatus is likely to be detected by the information analysis device. Thus, it is possible to accurately determine whether a detecting operation of the information analysis device is proper.
(7) A propriety determination method according to another aspect of the present invention of determining whether a detecting operation of an information analysis device is proper, wherein the information analysis device is configured to detect an abnormality in a substrate processing apparatus based on invariant relationships in regard to a plurality of processing information pieces representing operations or states relating to a process for a substrate by the substrate processing apparatus and a plurality of actually collected processing information pieces, and the propriety determination method includes generating dummy information by replacing at least part of the plurality of processing information pieces collected from the substrate processing apparatus with a dummy data piece and providing the dummy information to the information analysis device, and determining whether a detecting operation of the information analysis device is proper by determining whether the invariant relationships set in the information analysis device are adapted to the substrate processing apparatus based on whether, in a case in which the dummy information is provided to the information analysis device by the dummy information generator, an abnormality in the substrate processing apparatus has been detected by the information analysis device, and the dummy data piece is set such that an abnormality in the substrate processing apparatus is detected by the information analysis device when, in a case in which the invariant relationships set in the information analysis device are adapted to the substrate processing apparatus, the dummy information is provided to the information analysis device.

With this propriety determination method, in a case in which the invariant relationships set in the information analysis device are adapted to the substrate processing apparatus, when dummy information is provided to the information analysis device, an abnormality in the substrate processing apparatus is detected by the information analysis device. On the other hand, in a case in which the invariant relationships set in the information analysis device are not adapted to the substrate processing apparatus, when dummy information is provided to the information analysis device, an abnormality in the substrate processing apparatus is not be detected by the information analysis device. Therefore, it is possible to determine whether the invariant relationships set in the information analysis device are adapted to the substrate processing apparatus based on whether an abnormality in the substrate processing apparatus is detected by the information analysis device when dummy information is provided to the information analysis device. Thus, it is possible to easily determine whether a detecting operation of the information analysis device is proper.

### [Advantageous Effects of Invention]

An information analysis device can easily determine whether detection of an abnormality in a substrate processing apparatus is proper.

### [Brief Description of the Drawings]

[FIG. 1] Fig. 1 is a diagram for explaining the configuration of a propriety determination device according to one embodiment.
[FIG. 2] Fig. 2 is a diagram for explaining the specific example of calculation of deviation degrees.
[FIG. 3] Fig. 3 is a diagram for explaining the specific example of calculation of an abnormality score.
[FIG. 4] Fig. 4 is a block diagram for explaining the functional configuration of a propriety determination device according to the present embodiment.
[FIG. 5] Fig. 5 is a flowchart showing one example of the processes executed in a control device of a substrate processing apparatus.
[FIG. 6] Fig. 6 is a flowchart showing one example of an abnormality determining operation of determining an abnormality in the substrate processing apparatus performed by an information analysis device.
[FIG. 7] Fig. 7 is a flowchart showing one example of a propriety determining operation performed by the propriety determination device.

### [Description of Embodiments]

A propriety determination device and a propriety determination method according to one embodiment of the present invention will be described below with reference to the drawings. In the following description, a substrate refers to a semiconductor substrate, a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like.

### (1) Overall Configuration

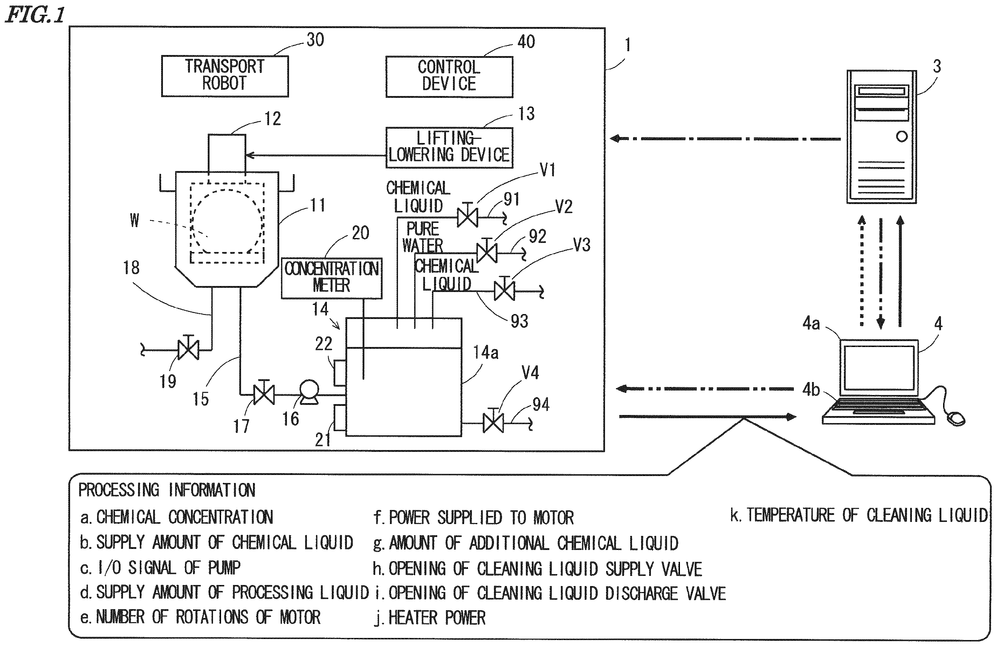

Fig. 1 is a diagram for explaining the configuration of the propriety determination device according to the one embodiment. As shown in Fig. 1, the propriety determination device 4 is connected to a substrate processing apparatus 1 and an information analysis device 3. The propriety determination device 4 is connected to each of the substrate processing apparatus 1 and the information analysis device 3 by a wired communication line or a wireless communication network. For example, the propriety determination device 4 is connected to each of the substrate processing apparatus 1 and the information analysis device 3 by a communication network such as the Internet. In the present embodiment, the propriety determination device 4 is connected to the substrate processing apparatus 1 and the information analysis device 3 by a wired or wireless LAN.

### (2) Example of Configuration of Substrate Processing Apparatus 1

In the example of Fig. 1, the substrate processing apparatus 1 is a batch-type substrate cleaning device, and includes a processing bath 11, a substrate holder 12, a lifting-lowering device 13, a cleaning liquid generation device 14, a concentration meter 20, a transport robot 30 and a control device 40. In the substrate processing apparatus 1, a display device, a speech output device and an operation unit (not shown) are provided in addition to the plurality of above-mentioned constituent elements.

The substrate holder 12 is configured to be capable of holding a plurality of substrates W. The processing bath 11 is configured to be capable of accommodating the plurality of substrates W held by the substrate holder 12. A cleaning liquid for cleaning the substrate W is stored in the processing bath 11.

The lifting-lowering device 13 supports the substrate holder 12 to be movable in an upward-and-downward direction and moves the substrate holder 12 in the upward-and-downward direction with the control of the control device 40. Thus, the lifting-lowering device 13 can immerse the plurality of substrates W held by the substrate holder 12 in the cleaning liquid stored in the processing bath 11, and can pull up the plurality of substrates W immersed in the cleaning liquid from the processing bath 11. The plurality of substrates W are cleaned by being immersed in the cleaning liquid. Further, in the lifting-lowering device 13, a motor (not shown) as a power source for moving the substrate holder 12 in the upward-and-downward direction is provided.

The cleaning liquid generation device 14 includes a storage tank 14a and a stirring device (a bubbling device or the like) (not shown). A chemical liquid supply pipe 91, a pure water supply pipe 92, an additional chemical liquid supply pipe 93 and a liquid drain pipe 94 are connected to the storage tank 14a. Valves V1 to V4 are respectively provided in the plurality of pipes (91 to 94). Each of the valves V1 to V4 is a control valve the opening of which is adjustable by the control of the control device 40.

The chemical liquid supply pipe 91 guides a chemical liquid supplied from a chemical liquid supply system (not shown) to the storage tank 14a when the valve V1 is opened. The flow rate (the supply amount per unit time) of the chemical liquid supplied to the storage tank 14a through the chemical liquid supply pipe 91 changes according to an opening of the valve V1.

The pure water supply pipe 92 guides a pure water supplied from a pure water supply system (not shown) to the storage tank 14a when the valve V2 is opened. The flow rate (the supply amount per unit time) of the pure water supplied to the storage tank 14a through the pure water supply pipe 92 changes according to an opening of the valve V2.

In this manner, the predetermined amounts of the chemical liquid and the pure water are stored in the storage tank 14a of the cleaning liquid generation device 14. Further, in the storage tank 14a, the chemical liquid and the pure water stored therein are mixed by a stirring mechanism (not shown), and a cleaning liquid to be stored in the processing bath 11 is generated. As the chemical liquid, BHF (Buffered Hydrofluoric Acid), DHF (Dilute Hydrofluoric Acid), hydrofluoric acid, hydrochloric acid, sulfuric acid, nitric acid, phosphoric acid, acetic acid, oxalic acid, ammonia, or the like is used.

The additional chemical liquid supply pipe 93 guides a chemical liquid supplied from the chemical liquid supply system (not shown) to the storage tank 14a when the valve V3 is opened. The supply of the chemical liquid to the storage tank 14a through the additional chemical liquid supply pipe 93 will be described below. The liquid drain pipe 94 discharges part or all of the cleaning liquid stored in the cleaning liquid generation device 14 to the outside of the substrate processing apparatus 1 when the valve V4 is opened.

A liquid supply pipe 15 is further connected to the storage tank 14a. The liquid supply pipe 15 is provided so as to connect the processing bath 11 and the cleaning liquid generation device 14 to each other. Further, a pump 16 and a valve 17 are provided in the liquid supply pipe 15. The valve 17 is a control valve the opening of which is adjustable by the control of the control device 40. When the valve 17 is opened during an operation of the pump 16, the cleaning liquid stored in the storage tank 14a is supplied into the processing bath 11. The flow rate of the cleaning liquid supplied to the processing bath 11 from the storage tank 14a changes according to an opening of the valve 17. A heater 21 and a thermal sensor 22 are provided in the storage tank 14a of the cleaning liquid generation device 14. The control device 40 controls electric power supplied to the heater 21. Thus, a temperature of the cleaning liquid is adjusted. A temperature of the cleaning liquid is detected by the thermal sensor 22.

A liquid discharge pipe 18 is connected to a bottom portion of the processing bath 11. A valve 19 is provided in the liquid discharge pipe 18. The valve 19 is a control valve the opening of which is adjustable by the control of the control device 40. When the valve 19 is opened, part of the cleaning liquid stored in the processing bath 11 is discharged from the substrate processing apparatus 1 through the liquid discharge pipe 18. The flow rate of the cleaning liquid discharged from the processing bath 11 changes according to an opening of the valve 19. During a cleaning process for the plurality of substrates W, the cleaning liquid is supplied from the cleaning liquid generation device 14 to the processing bath 11, and the cleaning liquid in the processing bath 11 is discharged through the liquid discharge pipe 18.

The concentration meter 20 detects a chemical concentration in the cleaning liquid stored in the storage tank 14a in response to an instruction provided by the control device 40, and provides a detection result to the control device 40. The transport robot 30 transports the plurality of substrates W held by the substrate holder 12 at a position farther upward than the processing bath 11. The control device 40 includes a CPU (Central Processing Unit) and a memory, for example, and controls an operation of the lifting-lowering device 13, an operation of the transport robot 30, open-close operations of the valves V1 to V4, openings of the valves 17, 19, and the like. The memory of the control device 40 stores a substrate processing program for execution of the above-mentioned substrate process executed by the substrate processing apparatus 1.

Further, based on the detection result of the chemical concentration provided by the concentration meter 20, the control device 40 performs feedback control of an amount of the chemical liquid supplied to the storage tank 14a such that the chemical concentration of the cleaning liquid stored in the storage tank 14a is within a predetermined range. For example, in a case in which the chemical concentration of the cleaning liquid detected by the concentration meter 20 is lower than the predetermined range, the control device 40 supplies an additional chemical liquid from the chemical liquid supply system (not shown) to the cleaning liquid generation device 14 through the additional chemical liquid supply pipe 93.

Further, the control device 40 has an emergency shutdown function for stopping an operation of the substrate processing apparatus 1 in a case in which a person enters a predetermined space inside of the substrate processing apparatus 1A or a predetermined detector (the concentration meter 20, for example) provided in the substrate processing apparatus 1 is not functioning.

### (3) Processing Information

In the substrate processing apparatus 1, as information for management of an abnormality in the substrate processing apparatus 1, a plurality of processing information pieces representing the operations or states relating to a process for the substrate W in the substrate processing apparatus 1 are defined. In the present embodiment, as indicated by the thick arrows in Fig. 1, these processing information pieces are transmitted from the control device 40 of the substrate processing apparatus 1 to the information analysis device 3 through the propriety determination device 4 in a predetermined period. These processing information pieces are directly transmitted from the control device 40 of the substrate processing apparatus 1 to the information analysis device 3 in a predetermined period.

As shown in the balloon of Fig. 1, the processing information pieces transmitted from the substrate processing apparatus 1 to the information analysis device 3 through the propriety determination device 4 include "a. CHEMICAL CONCENTRATION," "b. SUPPLY AMOUNT OF CHEMICAL LIQUID," "c. I/O SIGNAL OF PUMP," "d. SUPPLY AMOUNT OF PROCESSING LIQUID," "e. NUMBER OF ROTATIONS OF MOTOR," "f. POWER SUPPLIED TO MOTOR," "g. AMOUNT OF ADDITIONAL CHEMICAL LIQUID," "h. OPENING OF CHEMICAL LIQUID SUPPLY VALVE" and "i. OPENING OF CLEANING LIQUID DISCHARGE VALVE."

"a. CHEMICAL CONCENTRATION" indicates a chemical concentration of the cleaning liquid in the storage tank 14a detected by the concentration meter 20. "b. SUPPLY AMOUNT OF CHEMICAL LIQUID" indicates a flow rate of the cleaning liquid supplied from the chemical liquid supply pipe 91 to the storage tank of the cleaning liquid generation device 14. "b. SUPPLY AMOUNT OF CHEMICAL LIQUID" can be detected by provision of a flowmeter in the chemical liquid supply pipe 91, for example.

In the substrate processing apparatus 1, when the pump 16 is operated, and the valve 17 is opened, the processing liquid stored in the storage tank 14a is supplied into the processing bath 11. "c. I/O SIGNAL OF PUMP" is a signal for operating the pump 16 or stopping the operation of the pump 16 and is provided from the control device 40 to the pump 16. "d. SUPPLY AMOUNT OF PROCESSING LIQUID" indicates a flow rate of the processing liquid that is stored in the storage tank 15a and is supplied to the processing bath 11. "b. SUPPLY AMOUNT OF CHEMICAL LIQUID" can be detected by provision of a flowmeter in the liquid supply pipe 15, for example.

"e. NUMBER OF ROTATIONS OF MOTOR" is the number of rotations of the motor provided in the lifting-lowering device 13 and can be calculated by detection of the rotation speed of the motor using a rotation speed sensor, for example. "f. POWER SUPPLIED TO MOTOR" is an amount of power supplied to the motor provided in the lifting-lowering device 13 and can be detected using an ammeter, for example.

"g. AMOUNT OF ADDITIONAL CHEMICAL LIQUID" indicates a flow rate of a chemical liquid additionally supplied from the additional chemical liquid supply pipe 93 to the storage tank 14a such that the chemical concentration of the cleaning liquid stored in the storage tank 14a is in the predetermined range. "g. AMOUNT OF ADDITIONAL CHEMICAL LIQUID" can be detected by provision of a flowmeter in the additional chemical liquid supply pipe 93, for example. "h. OPENING OF CHEMICAL LIQUID SUPPLY VALVE" indicates an opening of the valve provided in the chemical liquid supply pipe 91. "i. OPENING OF CLEANING LIQUID DISCHARGE VALVE" indicates an opening of the valve provided in the liquid drain pipe 94.

"j. HEATER POWER" indicates the power supplied to the heater 21. "k. TEMPERATURE OF CLEANING LIQUID" indicates the power supplied to the heater 21 and the temperature of the cleaning liquid generated by the cleaning liquid generation device 14.

### (4) Detection of Abnormality in Substrate Processing Apparatus 1 by Information Analysis Device 3

The information analysis device 3 is a server, for example, and includes a CPU and a memory. The information analysis device 3 collects a plurality of processing information pieces transmitted from the substrate processing apparatus 1. In the information analysis device 3, in regard to the plurality of processing information pieces transmitted from the substrate processing apparatus 1 to the information analysis device 3, a plurality of combinations each combination of which includes two different processing information pieces are predetermined.

At this time, a predetermined invariant relationship (hereinafter referred to as an invariant relationship) between two processing information pieces that form each combination is maintained. The invariant relationship is set for each predetermined processing procedure (processing recipe) of the substrate processing apparatus 1.

Here, it is estimated that an inappropriate substrate process is executed because a substrate process is executed with an abnormality present in the substrate processing apparatus 1. In this case, at least the relationship between two processing information pieces forming one combination out of the plurality of combinations deviates from an invariant relationship.

The information analysis device 3 calculates a plurality of deviation degrees in regard to a plurality of pressing information pieces. A deviation degree indicates a degree of deviation from the predetermined invariant relationship between two processing information pieces to the relationship between two actually collected processing information pieces in regard to the two processing information pieces. Further, based on the plurality of calculated deviation degrees, the information analysis device 3 calculates a degree of abnormality in the substrate processing apparatus 1 as an abnormality score. The specific example of a method of calculating an abnormality score will be described below.

Further, as indicated by the thick one-dot and dash arrows in Fig. 1, the information analysis device 3 transmits a calculated abnormality score to the substrate processing apparatus 1. An abnormality score is transmitted each time an abnormality score is calculated in the information analysis device 3. At this time, each substrate processing apparatus 1 stores an abnormality score transmitted from the information analysis device 3.

Further, in regard to the substrate processing apparatus 1, the information analysis device 3 determines whether an abnormality score exceeds a predetermined abnormality determination threshold value. As indicated by the two-dots and dash arrow in Fig. 1, in a case in which an abnormality score exceeds the abnormality determination threshold value, the information analysis device 3 transmits a warning to the substrate processing apparatus 1 through the propriety determination device 4. Hereinafter, these operations are referred to as abnormality detecting operations of detecting an abnormality in the substrate processing apparatus 1.

In the present embodiment, an abnormality that does not require quick maintenance by a person who maintains and inspects the substrate processing apparatus 1 (hereinafter referred to as a maintenance worker) has a lower abnormality score (degree of abnormality), and an abnormality that requires quick maintenance by the maintenance worker has a higher abnormality score (degree of abnormality).

In case of a low abnormality score, it includes a case in which, it is predicted, based on the invariant relationships respectively corresponding to the plurality of above-mentioned combinations, that the deviation degrees in regard to all of a plurality of processing information pieces are in a normal range.

On the other hand, in case of a high abnormality score, it includes a case in which the actual temporal change of "d. CHEMICAL CONCENTRATION" is significantly larger than the temporal change of "d. CHEMICAL CONCENTRATION" that is predicted based on the temporal change of "b. SUPPLY AMOUNT OF CHEMICAL LIQUID," for example. When this state continues, it causes a processing defect in the substrate W, generation of a harmful gas, and damage to a component of the substrate processing apparatus 1, due to the inability to adjust the chemical concentration of the cleaning liquid.

Further, in case of a high abnormality score, it includes a state in which "f. POWER SUPPLIED TO MOTOR" is significantly larger than a predicted value, for example. In this state, it is highly likely that an unexpected load is applied to the motor. Therefore, when this state continues, it causes a failure in an operating portion including the motor, a failure in transport of the substrate W and damage to the component of the substrate processing apparatus 1.

Further, in case of a high abnormality score, is includes a state in which an actual value of "g. AMOUNT OF ADDITIONAL CHEMICAL LIQUID" varies beyond a predicted range, for example. In this state, it is difficult to maintain a constant concentration of the cleaning liquid. Therefore, when this state continues, it causes a processing failure in the substrate W.

Further, in case of a high abnormality score, it includes a state in which the actual temporal changes of "h. OPENING OF CHEMICAL LIQUID SUPPLY VALVE" and "i. OPENING OF CLEANING LIQUID DISCHARGE VALVE" are significantly different from the temporal changes of "h. OPENING OF CHEMICAL LIQUID SUPPLY VALVE" and "i. OPENING OF CLEANING LIQUID DISCHARGE VALVE" that are predicted based on "a. CHEMICAL CONCENTRATION" and "b. SUPPLY AMOUNT OF CHEMICAL LIQUID." In a case in which the substrate processing apparatus 1 is in this state, it is considered that the substrate processing apparatus 1 is stopped by the emergency shutdown function or is to be inherently stopped.

### (5) Example of Calculation of Abnormality Score in Information Analysis Device 3

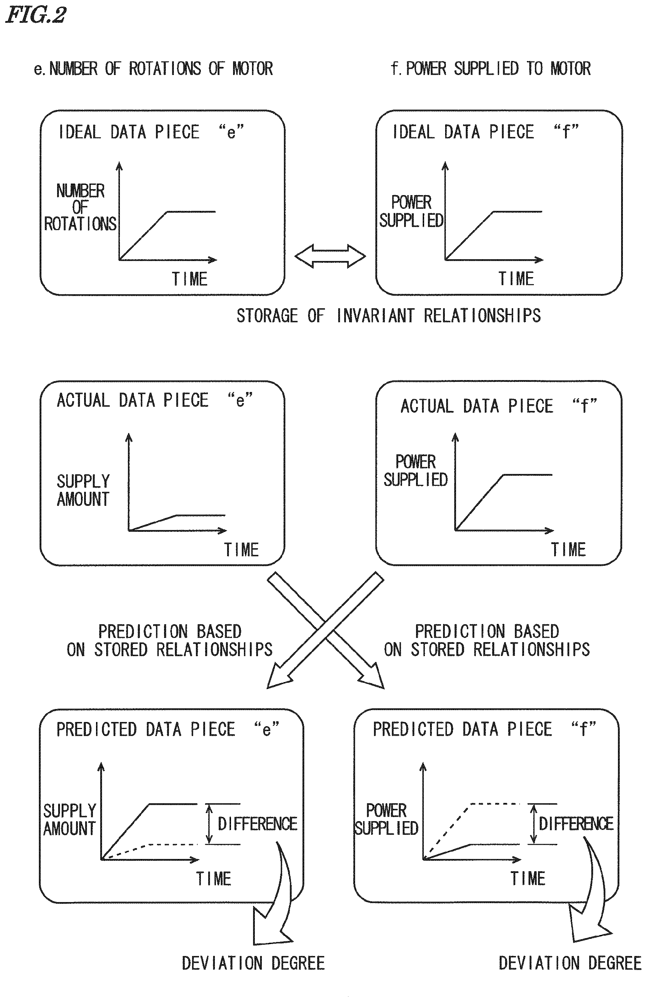

As described above, in the information analysis device 3, the plurality of combinations each of which includes two different processing information pieces are defined. In order to calculate an abnormality score, a deviation degree is calculated for each combination. Fig. 2 is a diagram for explaining the specific example of calculation of a deviation degree. Here, the example of calculation of a deviation degree corresponding to the combination of "b. NUMBER OF ROTATIONS OF MOTOR" and "f. POWER SUPPLIED TO MOTOR" of Fig. 1 is described. In the following description, the data of "e. NUMBER OF ROTATIONS OF MOTOR" is suitably referred to as a data piece "e," and the data of "f. POWER SUPPLIED TO MOTOR" is suitably referred to as a data piece "f."

In order to calculate the deviation degree, reference data based on the invariant relationship between "e. NUMBER OF ROTATIONS OF MOTOR" and "b. POWER SUPPLIED TO MOTOR" is required. As such, before a process is actually executed on a substrate W in the substrate processing apparatus 1, the information analysis device 3 holds a data piece "e" and a data piece "f" obtained when the substrate processing apparatus 1 is ideally operating in accordance with a predetermined processing recipe.

These ideal data piece "e" and ideal data piece "f" are acquired based on a plurality of processing information pieces transmitted from the substrate processing apparatus 1 when the substrate processing apparatus 1 is operating actually and normally, for example. Alternatively, the ideal data piece "e" and the ideal data piece "f" may be generated by simulation or the like.

One example of the temporal changes of the ideal data piece "e" and the ideal data piece "f" is shown by the graphs in the upper portion of Fig. 2. In the graph for the data piece "e," the abscissa indicates time, and the ordinate indicates the number of rotations of the motor. In the graph of the data piece "f," the abscissa indicates time, and the ordinate indicates an amount of power supplied to the motor provided in the lifting-lowering device 13 of Fig. 1. The abscissa (time axis) is common between the graph for the data piece "e" and the graph for the data piece "f."

According to the two graphs in the upper portion of Fig. 2, it is found that the power supplied to the motor increases at a substantially constant rate as the number of rotations of the motor increases. That is, the number of rotations of the motor and the power supplied to the motor has an invariant relationship. In a case in which the substrate processing apparatus 1 operates ideally, the relationship in each combination of the plurality of processing information pieces is equal to an invariant relationship. As such, in the information analysis device 3, an invariant relationship is stored for each combination of the plurality of processing information pieces. Thus, invariant relationships adapted to each substrate processing apparatus 1 are stored in the information analysis device 3.

In this state, the process is executed on the substrate W in the substrate processing apparatus 1, and an actual data piece "e" and an actual data piece "f" are collected by the information analysis device 3. One example of the temporal changes of the actually collected data piece "e" and the actually collected data piece "f" is shown by the graphs in the center portion of Fig. 2.

When the actual data piece "e" is collected, the data piece "f" is predicted based on the pre-stored invariant relationship. Further, when the actual data piece "f" is collected, the data piece "e" is predicted based on the pre-stored invariant relationship. One example of the temporal changes of the data piece "e" and the data piece "f" that are predicted based on the invariant relationship is shown by the graphs in the lower portion of Fig. 2. In the graphs in the lower portion of Fig. 2, the predicted data piece "e" and the predicted data piece "f" are indicated by the solid lines, and the actually collected data piece "e" and the actually collected data piece "f" are indicated by the dotted lines.

In a case in which the substrate processing apparatus 1 is ideally operating, the actual data piece "e" and the predicted data piece "e" coincide or substantially coincide with each other. Further, the actual data piece "f" and the predicted data piece "f" coincide or substantially coincide with each other. However, in a case in which an abnormality is present in the substrate processing apparatus 1, the actual data piece "e" and the predicted data piece "e" are likely to deviate from each other. The actual data piece "f" and the predicted data piece "f" are also likely to deviate from each other. It is considered that, the larger a degree of abnormality that occurs in the substrate processing apparatus 1, the larger a degree of deviation, and the smaller a degree of abnormality that occurs in the substrate processing apparatus 1, the smaller a degree of deviation.

As such, in the present embodiment, the difference value between the data which is actually collected processing information and the data which is predicted processing information is calculated as a deviation degree. In the example of Fig. 2, the information analysis device 3 calculates the difference value between the actual data piece "e" and the predicted data piece "e" as a deviation degree when calculating a deviation degree at a certain point in time. Further, the information analysis device 3 calculates the difference value between the actual data piece "f" and the predicted data piece "f" as a deviation degree.

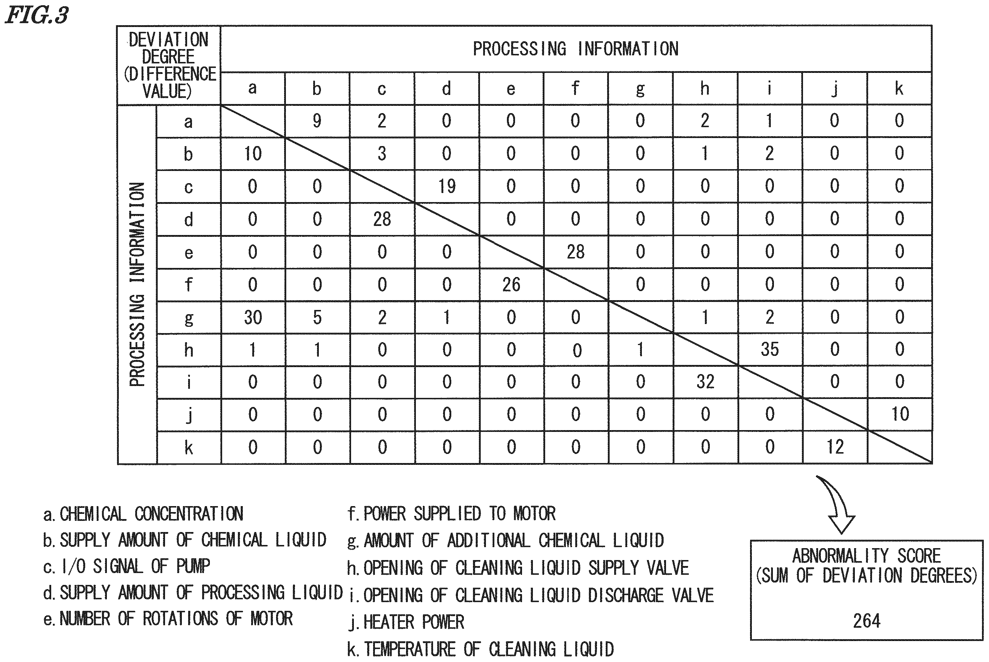

Fig. 3 is a diagram for explaining the specific example of calculation of an abnormality score. The information analysis device 3 calculates the above-mentioned deviation degrees for all combinations in regard to the plurality of processing information pieces. Each of the plurality of values arranged in the row at the right of each of the processing information pieces "a" to "k" in the left column of Fig. 3 represents the deviation degree between a processing information piece predicted based on each of the processing information pieces "a" to "k" in the upper row, and an actually acquired processing information piece. Each of the plurality of values arranged in the column below each of the processing information pieces "a" to "k" in the upper row of Fig. 3 represents the deviation degree between a processing information piece predicted based on each of the processing information pieces "a" to "k" in the left column, and an actually acquired processing information piece.

For example, the value "30" at the intersection of the row for the processing information piece "e" in the left column and the column for the processing information piece "f" in the upper row represents the deviation degree between the processing information piece "e" that is predicted based on the processing information piece "f" and the actually acquired processing information piece "e." Further, the value "28" at the intersection of the column for the processing information piece "e" in the upper row and the row for the processing information piece "f" in the left column represents the deviation degree between the processing information piece "f" that is predicted based on the processing information piece "e" and the actually acquired processing information piece "f."

Fig. 3 shows the plurality of deviation degrees calculated for all combinations in regard to the plurality of processing information pieces. When all of the deviation degrees are calculated, the information analysis device 3 calculates the sum of the plurality of calculated deviation degrees as an abnormality score. In the example of Fig. 3, the abnormality score is 264.

As described above, in the information analysis device 3, invariant relationships are set for each processing recipe of the substrate processing apparatus 1. Therefore, in a case in which a processing recipe of the substrate processing apparatus 1 is changed to another processing recipe, invariant relationships set in the information analysis device 3 need to be updated to be adapted to the other processing recipe. Further, in a case in which various appliances included in the substrate processing apparatus 1 are changed or updated, invariant relationships set in the information analysis device 3 need to be updated so as to be adapted to the changed or updated appliances. Hereinafter, a case in which an operation or a state relating to a process for a substrate in the substrate processing apparatus 1 is changed, such as a case in which a processing recipe of the substrate processing apparatus 1 is changed or any appliance included in the substrate processing apparatus 1 is changed or updated, is collectively referred to as a change in operation state of the substrate processing apparatus 1.

When an operation state of the substrate processing apparatus 1 is changed, invariant relationships set in the information analysis device 3 need to be updated so as to be adapted to a changed operation state of the substrate processing apparatus 1. After an operation state of the substrate processing apparatus 1 is changed, in a case in which invariant relationships set in the information analysis device 3 are not updated so as to be adapted to a changed operation state of the substrate processing apparatus 1, the information analysis device 3 cannot accurately detect an abnormality in the substrate processing apparatus 1. In this case, a detecting operation of the information analysis device 3 is improper. As such, the propriety determination device 4 that determines whether a detecting operation of the information analysis device 3 is proper is used.

### (6) Propriety Determination Device 4

As shown in Fig. 1, the propriety determination device 4 is a personal computer, for example, and includes a CPU and a memory. This propriety determination device 4 includes a display 4a and an operation unit 4b and is used by an administrator who manages the substrate processing apparatus 1 or the information analysis device 3, for example.

In the present embodiment, the propriety determination device 4 replaces at least part of a plurality of processing information pieces ("a" to "j" shown in Fig. 1 in the present example) transmitted from the substrate processing apparatus 1 with a predetermined value (hereinafter referred to as a dummy data piece). Thus, the propriety determination device 4 generates dummy information including the processing information pieces and the dummy data piece transmitted from the substrate processing apparatus 1. The propriety determination device 4 may generate dummy information by replacing all of the plurality of processing information pieces transmitted from the substrate processing apparatus 1 with dummy data pieces.

Here, dummy data pieces are set such that, when the dummy data pieces are provided to the information analysis device 3 in a case in which the invariant relationships set in the information analysis device 3 are adapted to the substrate processing apparatus 1, an abnormality score calculated by the information analysis device 3 reliably exceeds the predetermined abnormality determination threshold value. In this case, regardless of whether the substrate processing apparatus 1 is normal or abnormal, in a case in which the invariant relationships set in the information analysis device 3 are adapted to the substrate processing apparatus 1, the information analysis device 3 detects an abnormality in the substrate processing apparatus 1 when the dummy information is provided. When the dummy information is provided to the information analysis device 3, in a case in which the information analysis device 3 does not detect an abnormality, it can be determined that the invariant relationships set in the information analysis device 3 are not adapted to the substrate processing apparatus 1. In this case, it is determined that a detecting operation of the information analysis device 3 is improper.

As indicated by the thick dotted arrow, the propriety determination device 4 transmits dummy information to the information analysis device 3 in a predetermined period (a period longer than a predetermined period in which a plurality of processing information pieces are transmitted to the information analysis device 3, for example). Thus, the information analysis device 3 performs the above-mentioned abnormality detecting operation on the dummy information transmitted by the propriety determination device 4.

As a processing information piece to be replaced with a dummy data piece, a processing information piece relating to an appliance that is continuously operating during an operation of the substrate processing apparatus 1 among the appliances included in the substrate processing apparatus 1 can be used, for example. Further, a dummy data piece is set to a value deviating from the processing information piece relating to a constituent element. The processing information piece relating to an appliance that is continuously operating during an operation of the substrate processing apparatus 1 indicates a value different from 0, for example. In this case, "c. I/O SIGNAL OF PUMP" and "d. SUPPLY AMOUNT OF PROCESSING LIQUID" can be used as processing information pieces to be replaced with dummy data pieces. In this case, in the substrate processing apparatus 1 of Fig. 1, the flow rate of the processing liquid supplied into the processing bath 11 in a state in which the control device 40 has provided an instruction for operating the pump 16 is replaced with 0 as a dummy data piece. Further, "k. TEMPERATURE OF CHEMICAL LIQUID" can be used as a processing information piece to be replaced with a dummy data piece. In this case, in the substrate processing apparatus 1 of Fig. 1, a temperature of the chemical liquid detected by the thermal sensor 22 in a state in which the electric power supplied from the control device 40 to the heater 21 is controlled is replaced with 0 as a dummy data piece.

In a case in which a detecting operation of the information analysis device 3 is proper, the relationship between the processing information pieces including "c. I/O SIGNAL OF PUMP" and "d. SUPPLY AMOUNT OF PROCESSING LIQUID" deviates from an invariant relationship in the information analysis device 3, and an abnormality score calculated by the information analysis device 3 exceeds the predetermined abnormality determination threshold value. Thus, the information analysis device 3 transmits a warning to the propriety determination device 4.

On the other hand, in a case in which a detecting operation of the information analysis device 3 is improper, the relationship between the processing information pieces including "c. I/O SIGNAL OF PUMP" and "d. SUPPLY AMOUNT OF PROCESSING LIQUID" does not necessarily deviate from an invariant relationship. Therefore, an abnormality score calculated by the information analysis device 3 sometimes does not exceed the predetermined abnormality determination threshold value. In this case, the information analysis device 3 does not transmit a warning to the propriety determination device 4.

Thus, when a dummy information piece is transmitted, the propriety determination device 4 can determine whether invariant relationships set in the information analysis device 3 are adapted to the substrate processing apparatus 1 according to whether a warning has been received from the information analysis device 3. In this case, it is possible to determine whether a detecting operation of the information analysis device 3 is proper.

In the present embodiment, in a case in which receiving a warning from the information analysis device 3, the propriety determination device 4 determines that invariant relationships set in the information analysis device 3 are adapted to the substrate processing apparatus 1 and determines that a detecting operation of the information analysis device 3 is proper. Further, in a case in which not receiving a warning from the information analysis device 3, the propriety determination device 4 determines that invariant relationships set in the information analysis device 3 are not adapted to the substrate processing apparatus 1 and determines that a detecting operation of the information analysis device 3 is improper.

In the present embodiment, in a case in which having transmitted dummy information to the information analysis device 3, the propriety determination device 4 does not transmit a warning received from the information analysis device 3 to the substrate processing apparatus 1. This prevents a false warning from being transmitted to the substrate processing apparatus 1.

In a case in which a detecting operation of the information analysis device 3 is improper, the propriety determination device 4 causes the display 4a to display a warning indicating that a detecting operation of the information analysis device 3 is improper. Hereinafter, a series of operations of the propriety determination device 4 is referred to as a propriety determining operation.

### (7) One Example of Functional Configuration and Propriety Determining Operation of Propriety Determination Device 4

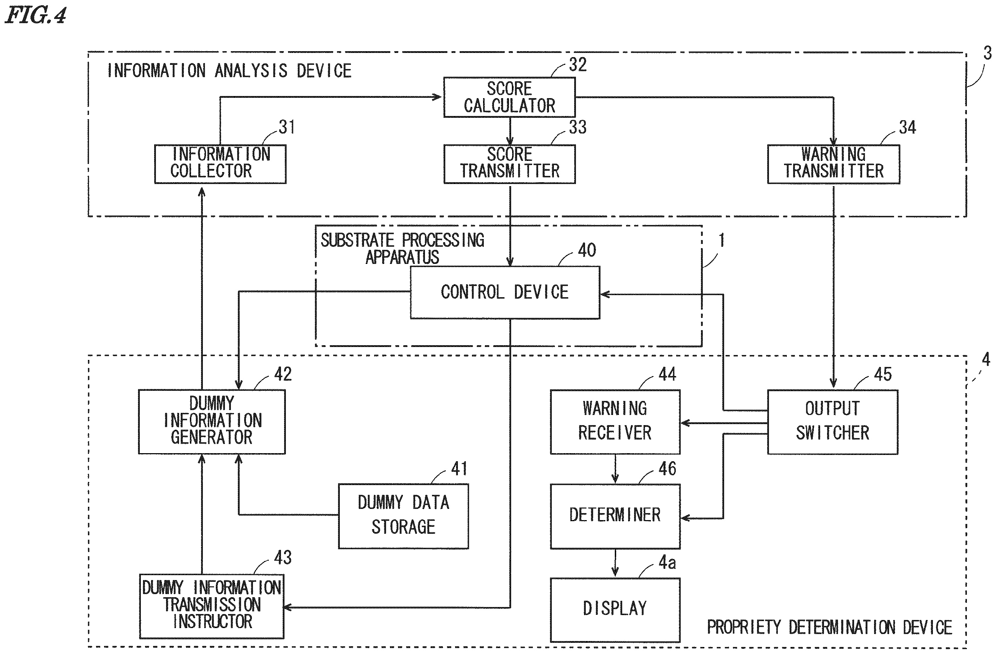

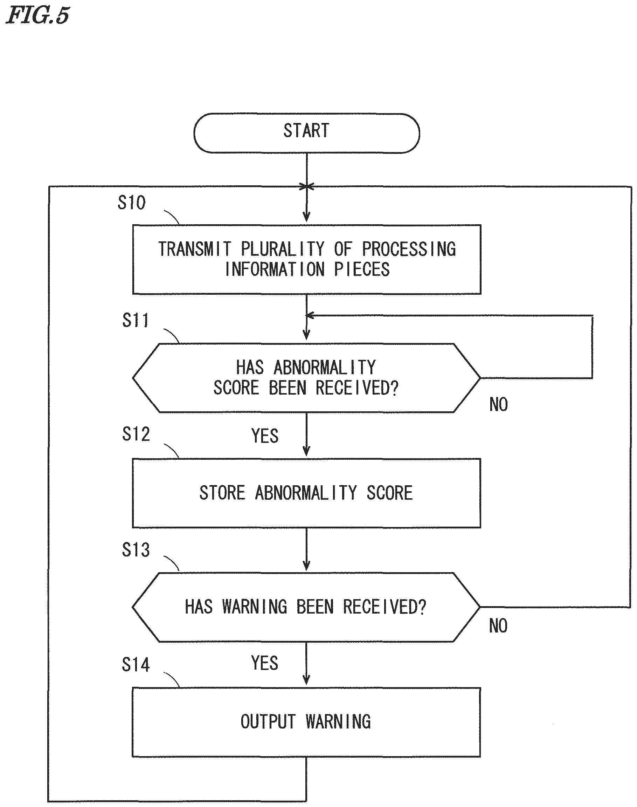

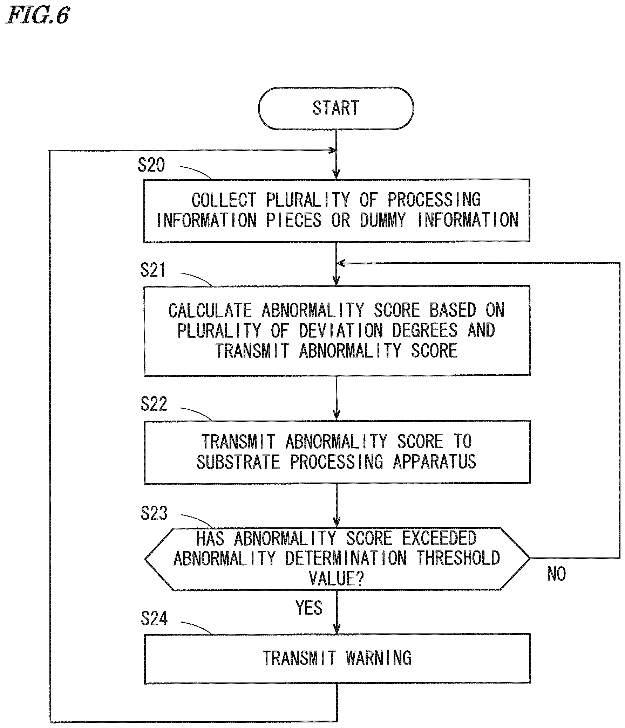

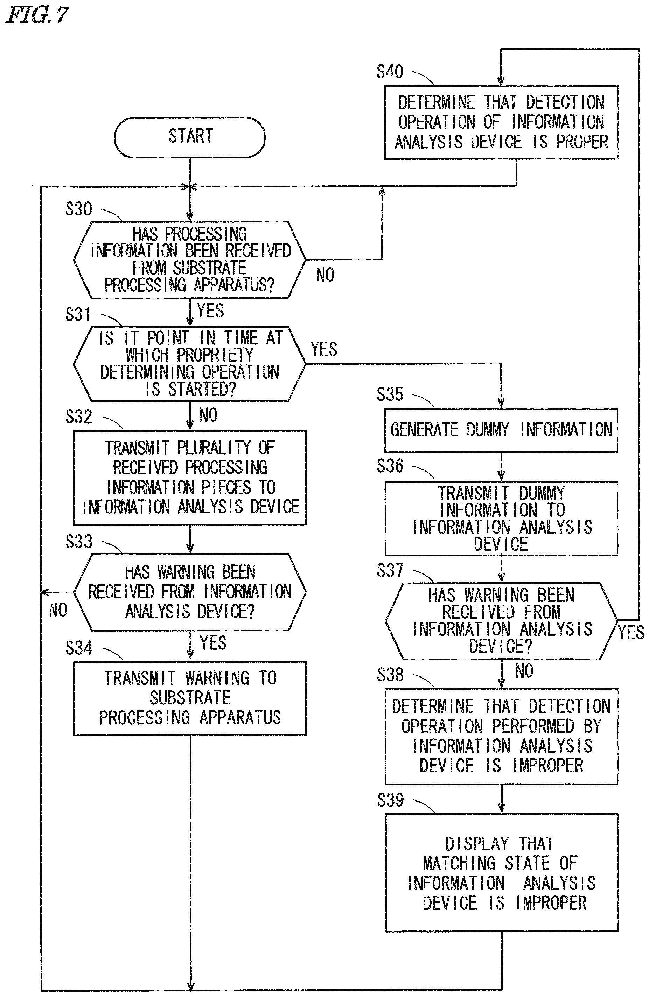

Fig. 4 is a block diagram for mainly explaining the functional configuration of the propriety determination device 4 according to the present embodiment. In Fig. 4, a block diagram for explaining the functional configurations of the substrate processing apparatus 1 and the information analysis device 3 is shown. Fig. 5 is a flowchart showing one example of the processes executed in the control device 40 (see Fig. 1) of the substrate processing apparatus 1. Fig. 6 is a flowchart showing one example of an operation of determining an abnormality in the substrate processing apparatus 1 performed in the information analysis device 3. Fig. 7 is a flowchart showing one example of a propriety determining operation performed in the propriety determination device 4.

As described with reference to Fig. 1, the substrate processing apparatus 1 includes the control device 40. The control device 40 transmits a plurality of processing information pieces acquired in the substrate processing apparatus 1 to the information analysis device 3 through the propriety determination device 4 (step S10 of Fig. 5). When transmitting the plurality of processing information pieces, the control device 40 may store the plurality of transmitted processing information pieces in association with the points in time at which the plurality of processing information pieces are transmitted.

Next, the control device 40 determines whether an abnormality score has been received from the information analysis device 3 (step S11). In a case in which not receiving an abnormality score, the control device 40 repeats the determination made in the step S11. In a case in which receiving an abnormality score, the control device 40 stores the received abnormality score in association with the point in time at which the abnormality score is received (step S12).

Further, the control device 40 determines whether a warning has been received from the information analysis device 3 (step S13). In a case in which not receiving a warning, the control device 40 ends the process. In a case in which receiving a warning, the control device 40 outputs a warning in the form of video or speech using the display device or the speech output device of the substrate processing apparatus 1 (step S14).

In Fig. 4, the information analysis device 3 includes an information collector 31, a score calculator 32, a score transmitter 33 and a warning transmitter 34. The memory of the information analysis device 3 stores a detecting operation execution program for execution of the above-mentioned abnormality detecting operation of detecting an abnormality in the substrate processing apparatus 1. The functions of the constituent elements (31 to 34) of the information analysis device 3 are implemented by execution of the detecting operation execution program by the CPU of the information analysis device 3. Part or all of the constituent elements (31 to 34) of the information analysis device 3 of Fig. 4 may be realized by hardware such as an electronic circuit.

The information collector 31 collects a plurality of processing information pieces or dummy information transmitted from the substrate processing apparatus 1 through the propriety determination device 4, and supplies the collected information to the score calculator 32 (step S20 of Fig. 6). The score calculator 32 calculates a plurality of deviation degrees based on the plurality of processing information pieces or the dummy information, calculates an abnormality score of the substrate processing apparatus 1, and provides the calculated abnormality score to the score transmitter 33 and the warning transmitter 34 (step S21).

The score transmitter 33 transmits the abnormality score calculated by the score calculator 32 to the substrate processing apparatus 1 (step S22). Here, in the substrate processing apparatus 1, the abnormality score transmitted from the score transmitter 33 is stored while being associated with a point in time at which the abnormality score is calculated, a point in time at which the abnormality score is transmitted or a point in time at which the abnormality score is received, for example.

The warning transmitter 34 determines whether the calculated abnormality score exceeds the abnormality determination threshold value (step S23). In a case in which the abnormality score does not exceed the abnormality determination threshold value, the warning transmitter 34 returns to the step S21. In a case in which the abnormality score exceeds the abnormality determination threshold value, the warning transmitter 34 transmits a warning to the one substrate processing apparatus 1 (step S24).

In Fig. 4, the propriety determination device 4 includes a dummy data storage 41, a dummy information generator 42, a dummy information transmission instructor 43, a warning receiver 44, an output switcher 45, a determiner 46 and a display 4a. The memory of the propriety determination device 4 stores a propriety determination program for execution of the propriety determining operation. The functions of the constituent elements (41 to 46) of the propriety determination program are implemented by execution of the propriety determination program by the CPU of the propriety determination device 4. Part or all of the constituent elements (41 to 49) of the propriety determination device 4 of Fig. 4 may be realized by hardware such as an electronic circuit.

The dummy data storage 41 stores a dummy data piece in advance. The dummy information generator 42 determines whether a plurality of processing information pieces have been received from the substrate processing apparatus 1 (step S30 of Fig. 7). In a case in which not receiving a plurality of processing information pieces from the substrate processing apparatus 1, the dummy information generator 42 repeats the determination of the step S30. In a case in which the dummy information generator 42 receives a plurality of processing information pieces from the substrate processing apparatus 1, the dummy information transmission instructor 43 determines whether a current point in time is a point in time at which the propriety determining operation is started (step S31).

In a case in which the current point in time is not the point in time at which the propriety determining operation is started in the step S31, the dummy information generator 42 transmits the plurality of processing information pieces received from the substrate processing apparatus 1 to the information analysis device 3 (step S32). Here, an abnormality detecting operation (the above-mentioned steps S20 to S24 of Fig. 6) is performed in the information analysis device 3. The warning receiver 44 determines whether the output switcher 45 has received a warning from the information analysis device 3 (step S33). In a case in which the output switcher 45 has not received a warning from the information analysis device 3, the operation of the step S30 is performed. In a case in which the output switcher 45 has received a warning from the information analysis device 3, the output switcher 45 transmits a warning to the substrate processing apparatus 1 (step S34). Thereafter, the operation of the step S30 is performed.

In a case in which the current point in time is the point in time at which the propriety determining operation is started in the step S31, the dummy information generator 42 generates dummy information by replacing at least part of the plurality of processing information pieces received from the substrate processing apparatus 1 with a dummy data piece (step S35). Next, the dummy information generator 42 transmits the dummy information to the information collector 31 of the information analysis device 3 based on an instruction provided by the dummy information transmission instructor 43 (step S36). Here, the abnormality detecting operation (the above-mentioned steps S20 to S24 of Fig. 6) is performed in the information analysis device 3. The warning receiver 44 determines whether the output switcher 45 has received a warning from the information analysis device 3 (step S37). In a case in which the output switcher 45 receives a warning from the information analysis device 3, the determiner 46 determines that a detecting operation of the information analysis device 3 is proper. Thereafter, the determiner 46 returns to the step S30. In a case in which the output switcher 45 has not received a warning from the information analysis device 3, the determiner 46 determines that a detecting operation of the information analysis device 3 is improper (step S38). In this case, a warning indicating that the detecting operation of the information analysis device 3 is improper is displayed on the display 4a of the propriety determination device 4 (step S39). Thereafter, the determination in the step S30 is made.

### (8) Effects of Embodiments

With the propriety determination device 4 of the above-mentioned embodiment, in a case in which invariant relationships set in the information analysis device 3 are adapted to the substrate processing apparatus 1, when dummy information is provided to the information analysis device 3, an abnormality in the substrate processing apparatus 1 is detected by the information analysis device 3. On the other hand, in a case in which invariant relationships set in the information analysis device 3 are not adapted to the substrate processing apparatus 1, when dummy information is provided to the information analysis device 3, an abnormality in the substrate processing apparatus 1 may not be detected by the information analysis device 3. Therefore, it is possible to determine whether the invariant relationships set in the information analysis device 3 are adapted to the substrate processing apparatus 1 based on whether an abnormality in the substrate processing apparatus 1 is detected by the information analysis device 3 when dummy information is provided to the information analysis device 3. Thus, it is possible to determine whether a detecting operation of the information analysis device 3 is proper.

Further, the determiner 46 of the propriety determination device 4 determines that a detecting operation of the information analysis device 3 is improper in a case in which an abnormality in a substrate is not detected by the information analysis device 3 when dummy information is provided to the information analysis device 3 by the dummy information generator 42. In this case, it is possible to easily determine that a detecting operation of the information analysis device is improper.

Further, in a case in which it is determined that a detecting operation of the information analysis device 3 is improper, the display 4a displays a warning indicating that the detecting operation of the information analysis device 3 is improper. Thus, the administrator can recognize easily and quickly that a detecting operation of the information analysis device is improper.

Further, the dummy information generator 42 transmits any one of a plurality of processing information pieces and dummy information collected from the substrate processing apparatus 1 based on an instruction for transmitting dummy information provided by the dummy information transmission instructor 43. In this case, it is possible to appropriately switch between an abnormality detecting operation of detecting an abnormality in the substrate processing apparatus 1 and determination, made by the propriety determination device 4, whether a detecting operation of the information analysis device 3 is proper with an instruction provided by the dummy information transmission instructor 43.

Further, in a case in which dummy information is provided to the information analysis device 3, the output switcher 45 does not transmit a received result of the detecting operation of the information analysis device 3 to the substrate processing apparatus 1. In this case, when whether a detecting operation of the information analysis device 3 is proper is determined, a result of detection indicating an abnormality in the substrate processing apparatus 1 caused by dummy information is prevented from being provided to the substrate processing apparatus 1. Thus, a user is prevented from erroneously identifying whether the substrate processing apparatus 1 of the substrate processing apparatus 1 is abnormal.

Further, the dummy information generator 42 replaces a processing information piece relating to a continuously operating constituent element among a plurality of constituent elements included in the substrate processing apparatus 1 with a dummy data piece. Further, a dummy data piece is set to a value deviating from the processing information piece relating to the constituent element. In this case, in a case in which invariant relationships set in the information analysis device 3 are adapted to the substrate processing apparatus 1, when dummy information is provided to the information analysis device 3, an abnormality in the substrate processing apparatus 1 is likely to be detected by the information analysis device 3. Thus, it is possible to accurately determine whether a detecting operation of the information analysis device 3 is proper.

### (9) Other Embodiments

(9-1) While the substrate processing apparatus 1 is a batch-type substrate cleaning device in the above-mentioned embodiment, the present invention is not limited to this. Further, the substrate processing apparatus 1 may be a single-wafer substrate cleaning device instead of a batch substrate cleaning device, or may have a configuration for executing a process other than a cleaning process. For example, the substrate processing apparatus 1 may be another substrate processing apparatus such as a coating device, a developing device, a heating device, a cooling device or a transport device.

(9-2) While including the dummy data storage 41 in the above-mentioned embodiment, the propriety determination device 4 does not have to include the dummy data storage 41. In this case, the dummy information generator 42 of the propriety determination device 4 may acquire a dummy data piece from a cloud on the Internet, for example. In this case, the number of constituent elements of the propriety determination device 4 is reduced. Further, the dummy data storage 41 can be shared by a plurality of propriety determination devices 4.

(9-3) While a plurality of processing information pieces of the substrate processing apparatus 1 are transmitted to the information analysis device 3 through the propriety determination device 4 in the above-mentioned embodiment, a plurality of information processing pieces may be directly transmitted to the information analysis device 3. In this case, the plurality of processing information pieces of the substrate processing apparatus 1 may be transmitted to the propriety determination device 4 only at a point in time at which a proper determining operation of the propriety determination device 4 is started. Alternatively, only at a point in time at which the propriety determining operation of the propriety determination device 4 is started, the dummy information generator 42 may replace all of a plurality of processing information pieces with dummy data pieces, so that the dummy data pieces are transmitted to the information analysis device 3.

(9-4) While the dummy information generator 42 transmits dummy information to the information collector 31 of the information analysis device 3 based on an instruction provided by the dummy information transmission instructor 43 in the above-mentioned embodiment, the present invention is not limited to this. For example, the dummy information generator 42 may transmit the dummy information to the information collector 31 of the information analysis device 3 at a point in time at which an instruction is provided by the administrator through the operation unit 4b of the propriety determination device 4. In this case, the dummy information transmission instructor 43 does not have to be provided in the propriety determination device 4. This reduces the number of functional constituent elements of the propriety determination device 4.

(9-5) While being is transmitted to the substrate processing apparatus 1 through the propriety determination device 4 in the above-mentioned embodiment, a warning of the information analysis device 3 may be directly transmitted to the substrate processing apparatus 1. In this case, the output switcher 45 may acquire only a warning transmitted during the propriety determining operation of the propriety determination device 4.

(9-6) In the above embodiment, in a case in which a detecting operation of the information analysis device 3 is improper in the propriety determination device 4, a warning indicating that the detecting operation of the information analysis device 3 is improper is displayed on the display 4a. However, the present invention is not limited to this. In a case in which a detecting operation of the information analysis device 3 is improper in the propriety determination device 4, a warning may be provided by lighting of a lamp or the like, a warning may be displayed on a screen of the display device or a warning may be output by a speech.

(9-7) While the substrate processing apparatus 1 and the information analysis device 3 are provided separately in the above-mentioned embodiment, the substrate processing apparatus 1 and the information analysis device 3 may be provided integrally. While the information analysis device 3 and the propriety determination device 4 are provided separately in the above-mentioned embodiment, the information analysis device 3 and the propriety determination device 4 may be provided integrally.

## Claims

1. A propriety determination device that determines whether a detecting operation of an information analysis device is proper, the information analysis device being configured to detect an abnormality in a substrate processing apparatus based on invariant relationships in regard to a plurality of processing information pieces representing operations or states relating to a process for a substrate by the substrate processing apparatus and a plurality of actually collected processing information pieces, comprising:
a dummy information generator that generates dummy information by replacing at least part of the plurality of processing information pieces collected from the substrate processing apparatus with a dummy data piece and provides the dummy information to the information analysis device; and
a determiner that determines whether a detecting operation of the information analysis device is proper by determining whether the invariant relationships set in the information analysis device are adapted to the substrate processing apparatus based on whether, in a case in which the dummy information is provided to the information analysis device by the dummy information generator, an abnormality in the substrate processing apparatus has been detected by the information analysis device, wherein
the dummy data piece is set such that an abnormality in the substrate processing apparatus is detected by the information analysis device when, in a case in which the invariant relationships set in the information analysis device are adapted to the substrate processing apparatus, the dummy information is provided to the information analysis device.

2. The propriety determination device according to claim 1, wherein
the determiner determines that a detecting operation of the information analysis device is improper in a case in which, when the dummy information is provided to the information analysis device by the dummy information generator, an abnormality in the substrate processing apparatus is not detected by the information analysis device.

3. The propriety determination device according to claim 1 or 2, further comprising a notifier that makes notification that a detecting operation of the information analysis device is improper in a case in which, when the dummy information is provided to the information analysis device, it is determined that the detecting operation of the information analysis device is improper.

4. The propriety determination device according to any one of claims 1 to 3, further comprising a dummy information transmission instructor that provides, to the dummy information generator, an instruction for transmitting the dummy information to the information analysis device, wherein
the dummy information generator, in a case in which the dummy information transmission instructor has not provided the instruction for transmitting the dummy information, transmits the plurality of processing information pieces collected from the substrate processing apparatus to the information analysis device, and in a case in which the dummy information transmission instructor has provided the instruction for transmitting the dummy information, transmits the dummy information generated by the dummy information generator to the information analysis device.

5. The propriety determination device according to any one of claims 1 to 4, further including an output switcher that receives a result in regard to a detecting operation of the information analysis device and transmits the received result in regard to the detecting operation to the substrate processing apparatus or the determiner, wherein
in a case in which the dummy information is provided to the information analysis device, the output switcher does not transmit the received result in regard to the detecting operation to the substrate processing apparatus.

6. The propriety determination device according to any one of claims 1 to 5, wherein
the dummy information generator replaces a processing information piece relating to a continuously operating constituent element among a plurality of constituent elements included in the substrate processing apparatus with the dummy data piece, and the dummy data piece is set to a value deviating from the processing information piece relating to the constituent element.

7. A propriety determination method of determining whether a detecting operation of an information analysis device is proper, the information analysis device being configured to detect an abnormality in a substrate processing apparatus based on invariant relationships in regard to a plurality of processing information pieces representing operations or states relating to a process for a substrate by the substrate processing apparatus and a plurality of actually collected processing information pieces, including:
generating dummy information by replacing at least part of the plurality of processing information pieces collected from the substrate processing apparatus with a dummy data piece and providing the dummy information to the information analysis device; and
determining whether a detecting operation of the information analysis device is proper by determining whether the invariant relationships set in the information analysis device are adapted to the substrate processing apparatus based on whether, in a case in which the dummy information is provided to the information analysis device by the dummy information generator, an abnormality in the substrate processing apparatus has been detected by the information analysis device, wherein
the dummy data piece is set such that an abnormality in the substrate processing apparatus is detected by the information analysis device when, in a case in which the invariant relationships set in the information analysis device are adapted to the substrate processing apparatus, the dummy information is provided to the information analysis device.
